Europäisches Patentamt

European Patent Office

Office européen des brevets

(19)

(11) Publication number: **0 114 066 B1**

(12) **EUROPEAN PATENT SPECIFICATION**

(45) Date of publication of patent specification: **12.06.91**

(51) Int. Cl.⁵: **H04B 7/185, H03G 3/20**

(21) Application number: **84100289.2**

(22) Date of filing: **12.01.84**

(54) Automatic gain control circuit for burst signal communication system.

(30) Priority: **14.01.83 JP 4745/83**

(43) Date of publication of application:
**25.07.84 Bulletin 84/30**

(45) Publication of the grant of the patent:
**12.06.91 Bulletin 91/24**

(84) Designated Contracting States:
**DE FR GB IT**

(56) References cited:
**DE-A- 2 158 985**
**DE-A- 2 161 657**
**GB-A- 1 342 383**
**US-A- 4 313 089**

**PATENTS ABSTRACTS OF JAPAN, vol. 5, no.**
**129 (E-70) [801], 19th August 1981; & JP - A -**
**56 66 916 (NIPPON DENKI K.K.) 05-06-1981**

**NTC'77 CONFERENCE RECORD, vol. 3, 1977,**
**pages 43:2-1 - 43:2-3, IEEE, New York, US;**
**D.J. SCHAEFER: "A technique for TDMA**
**burst power measurement"**

**PATENTS ABSTRACTS, vol. 4, no. 67 (E-11)**
**[549], 20th May 1980, page 55 E 11; & JP - A -**
**55 35 513 (MITSUBISHI DENKI K.K.)**

12-03-1980

**PATENTS ABSTRACTS OF JAPAN, vol. 4, no.**
**162 (E-33) [644], 12th November 1980, page**
**644 E 33; & JP - A - 55 110 447 (NIPPON**
**DENKI K.K.) 25-08-1980**

(73) Proprietor: **NEC CORPORATION**
**7-1, Shiba 5-chome Minato-ku**
**Tokyo 108-01(JP)**

(72) Inventor: **Tanimoto, Yoshio**
**c/o NEC CORPORATION 33-1, Shiba 5-chome**
**Minato-ku Tokyo(JP)**
Inventor: **Atobe, Masaaki**
**c/o NEC Corporation 33-1, Shiba 5-chome**
**Minato-ku Tokyo(JP)**

(74) Representative: **Vossius & Partner**
**Siebertstrasse 4 P.O. Box 86 07 67**
**W-8000 München 86(DE)**

## Description

### BACKGROUND OF THE INVENTION

The present invention relates to an automatic gain control (AGC) circuit for use in the transmission and reception of burst signals in a time division multiple access (TDMA) system or the like.

One of the systems used in satellite communication and the like is known as the burst communication system, in which a transmitting action is performed only when information is to be conveyed. This burst communication system has the advantages that the power consumption can be reduced and that the same satellite and the same frequency band can be used for communication between multiple transmitting and receiving stations.

An AGC amplifier is used, in a transmitter for the burst communication system, for keeping constant the variation of transmitting power which is caused by temperature fluctuation or switching of the transmission path. In a receiver, an AGC amplifier is used for keeping constant the variation of the reception input power and thereby stabilizing the demodulating action. It is customary in such an AGC circuit for burst signals to achieve AGC by the use of a charging/discharging or time constant circuit having a peak holding function as the negative feedback biasing circuit of the AGC amplifier.

However, a conventional AGC circuit for burst signals, as will be described in detail below, has the disadvantage that a change in burst time would invite a variation in the output power of the AGC circuit, so that it could not achieve its intended purpose to keep the output power constant. As a result, if the circuit is used in a transmitter, the transmitting power may vary or, if it is used in a receiver, the input to the demodulator circuit may vary to adversely affect its receiving function. US-A-4,313,089 describes an AGC circuit with a negative feedback circuit having an envelope detector for the output signal, a signal converter with digital output and a digitally controllable amplifier. GB-A-1,342,383 describes a similar AGC circuit with a logic circuit between the comparator and the amplifier.

### SUMMARY OF THE INVENTION

An object of the present invention, therefore, is to provide an AGC circuit for burst signals, whose output power will not vary regardless of variation in the burst time.

According to the invention, there is provided an automatic gain control (AGC) circuit for a burst signal communication system, comprising an AGC amplifier means for receiving a burst input and providing a burst output whose level is controlled in response to a control signal, and a negative feedback circuit means for receiving the burst output and providing the control signal, wherein the negative feedback circuit means comprises an envelope detector means for envelope detecting the burst output and providing a first signal, converting means for converting the first signal into a binary signal by comparing it with a reference voltage, pulse generator means for providing a pulse signal of a predeterminal pulse width in response to the binary signal, and AGC amplifier driving circuit means for digitally processing the pulse signal, thereby providing the control signal.

### BRIEF DESCRIPTION OF THE DRAWINGS

Other features and advantages of the invention will be more apparent from the detailed description hereunder taken in conjunction with the accompanying drawings, wherein:

FIG. 1 is a block diagram illustrating the structure of a prior art AGC circuit for burst signals;

FIGS. 2A to 2C are diagrams specifically depicting the operation of the circuit illustrated in FIG. 1;

FIG. 3 is a block diagram illustrating one preferred embodiment of the AGC circuit for burst signals according to the present invention;

FIG. 4 shows a specific embodiment of the one-shot trigger circuit illustrated in FIG. 3;

FIGS. 5A, 5B, 5C', 5C'' and 5C''' are waveform diagrams for describing the operations of the signal converter and the one-shot trigger circuit;

FIG. 6 shows a specific embodiment of the reversible counter illustrated in FIG. 3;

FIGS. 7A(a) to 7A(c), 7B(a) to 7B(c), 7C(a) to 7C(c) and 7D(a) to 7D(c) are waveform diagrams for describing the operation of the circuit illustrated in FIG. 3;

FIG. 8 is a block diagram illustrating another preferred embodiment of the AGC circuit for receiving burst signals, representing an improvement over the circuit shown in FIG. 3, and

FIGS. 9A and 9B are waveform diagrams for describing the operation of the circuit illustrated in FIG. 8.

### DETAILED DESCRIPTION OF THE INVENTION

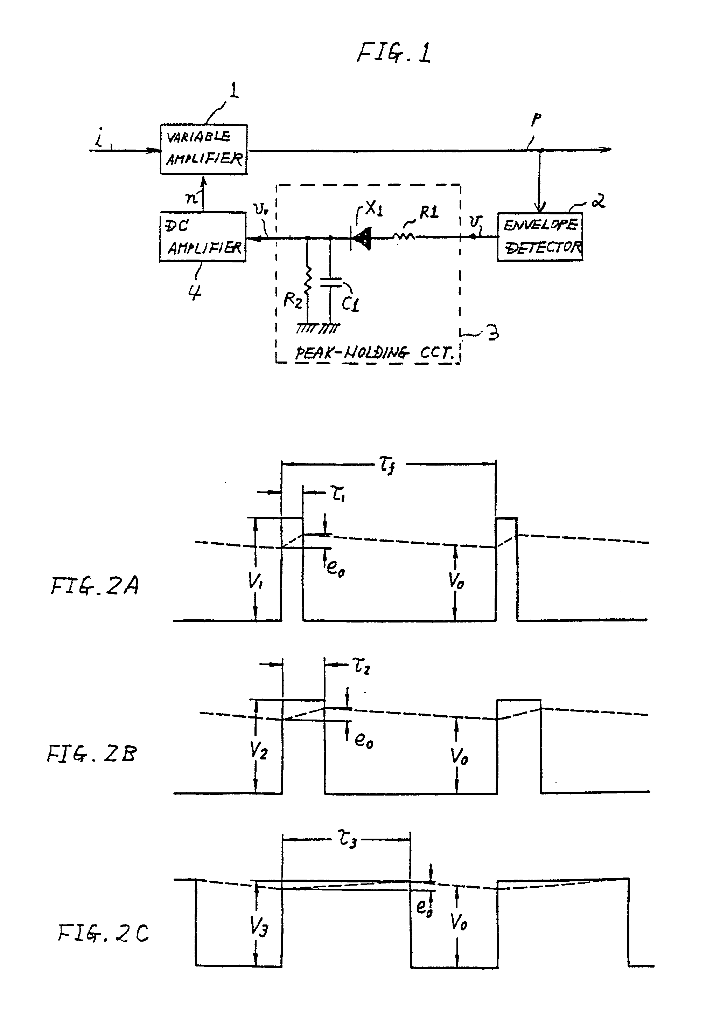

FIG. 1 is a block diagram illustrating the structure of a prior art AGC circuit for burst signals. In FIG. 1, the AGC circuit comprises a variable amplifier (or an AGC amplifier) 1, an envelope detector 2, a peak holding circuit 3 and a D.C. amplifier 4. The peak holding circuit 3 comprises a peak holding capacitor C1, a peak holding diode $X_1$ and resistors $R_1$ and $R_2$. The diode $X_1$, upon arrival of

a burst signal, drops in resistance and makes possible electric charging but, in the absence of a burst signal, rises in resistance to keep the electric charge. The resistor $R_1$ determines the charging time, and the high resistor $R_2$ determines the discharging time. The D.C. amplifier 4 is high both in gain and in input impedance to prevent the electric charge of the capacitor $C_1$ from being discharged. In the peak-holding circuit 3, the charging time $\tau a$ is determined by $\tau a = R_1 C_1$, and the discharging time $\tau b$, by $\tau b = R_2 C_1$.

The operation of the circuit will be described next. A burst signal i is applied through a modulator and frequency converter (not shown), for example, to the variable amplifier 1 which amplifies the burst signal i in response to a control voltage n and provides a burst output signal p. The envelope detector 2 envelope-detects the signal p and provides a detecting voltage v, which is peak-held by charging the capacitor $C_1$ through the diode $X_1$. The detecting voltage v thereby peak-held, after being amplified by the D.C. amplifier 4, becomes the control voltage n, which keeps constant the level of the burst output signal p of the variable amplifier 1. Thus, the AGC circuit includes a negative feedback circuit consisting of the detector 2, the circuit 3 and the amplifier 4.

The characteristics of AGC circuit are determined by the control voltage-amplification relationship of the variable amplifier 1, the detecting sensitivity of the envelope detector 2, the amplification gain of the D.C. amplifier 4 and other pertinent characteristics. Also, in determining the charging time $\tau a$ and the discharging time $\tau b$ in the peak-holding circuit 3, the frame cycle $\tau f$ and burst time $\tau$ of the burst signal i are taken into account. It is more desirable for $\tau a$ to be smaller to make the AGC circuit quicker in response, and $\tau b$ should preferably be greater to stabilize the peak-holding performance. To give a typical set of parameters, if $\tau f = 750\ \mu s$, $\tau = 1\ \mu s$, $\tau a = \tau \times 10 = 10\ \mu s$ and $\tau b = \tau f \times 100 = 75\ ms$, then $C_1 = 0.1\ \mu F$, $R_1 = 100\ \Omega$ and $R_2 = 750\ K\Omega$. According to this example, the charging will be substantially completed when some 10 burst signals (10 frames) have arrived. If no burst signals corresponding to 100 frame times have arrived, it will mean that the electric charge of the capacitor $C_1$ is discharged.

Whereas the burst time varies in a TDMA communications system because the quantity of information is variable with the demand of the communicating stations, the charging and discharging responses will also change with these variations.

FIGS. 2A to 2C are diagrams specifically depicting the operation of the AGC circuit described above and show three different examples of burst time, wherein solid lines represent the detection output of the envelope detector 2, i.e. the input voltage v to the peak holding diode $X_1$ and broken lines, the time response of the voltage $v_0$ resulting from the charging of the capacitor $C_1$ with said detection output v. These FIGS. 2A to 2C illustrate the states in which the voltage charged upon arrival of a burst is discharged through the resistor $R_2$ in the absence of a burst, and the charge and the discharge are equivalent and stably in an equilibrium. In FIG. 2A, $\tau f/\tau 1 = 10$; in FIG. 2B, $\tau f/\tau 2 = 5$; and in FIG. 2C, $\tau f/\tau 3 = 1.67$ ($\tau 1$ through $\tau 3$ are burst times and $\tau f$ is the frame time). Although the $\tau f/\tau$ ratios in FIGS. 2A to 2C are taken smaller than they really are with a view to simplifying the explanation, they have to be greater in an actual circuit: $\tau f/\tau 1 = 1000$ for FIG. 2A, $\tau f/\tau 2 = 100$ for FIG. 2B, and $\tau f/\tau 3 = 10$ for FIG. 2C.

As the positions of the broken lines in FIGS. 2A to 2C indicate, the AGC circuit so operates through its negative feedback circuit that, even if the length of the arriving burst $\tau$ ($\tau 1$, $\tau 2$ or $\tau 3$) varies, the voltage $v_0$ kept in the capacitor $C_1$ remain substantially the same. Therefore, because there is required such a charge as will compensate for the electric potential $e_0$ discharged by the discharging resistor $R_2$ within the burst time even if the time becomes shorter, the three voltage values $V_3$, $V_2$ and $V_1$ manifested by the amplified detecting voltage v for charging will increase in this order as the burst time successively shortens from $\tau 3$ to $\tau 1$ and, if the value of voltage retained by the capacitor $C_1$ is $V_0$, the voltage $(V_3 - V_0)$, $(V_2 - V_0)$ and $(V_1 - V_0)$ working on the diode $X_1$ and the two ends of the resistor $R_1$ will also increase in this order, with the result that the charging current grows and the potential $e_0$ is compensated for so that sufficient charging can be achieved even if the charging time is short. However, the variation in the envelope detection voltage V ($V_1$, $V_2$, $V_3$) shows said variation in the input power to the envelope detector 2, i.e. the burst output signal p. Therefore, as stated earlier, a change in burst time in this prior art AGC circuit for burst signals would entail a variation in the output power of the AGC circuit. This is inconsistent with the intended purpose of the AGC circuit to keep its output power constant and, if for instance this circuit is used in a transmitter, will invite a variation in transmitted power. Or, if it is applied to a receiver, the input to the decoder circuit will vary and consequently the receiving function will be adversely affected.

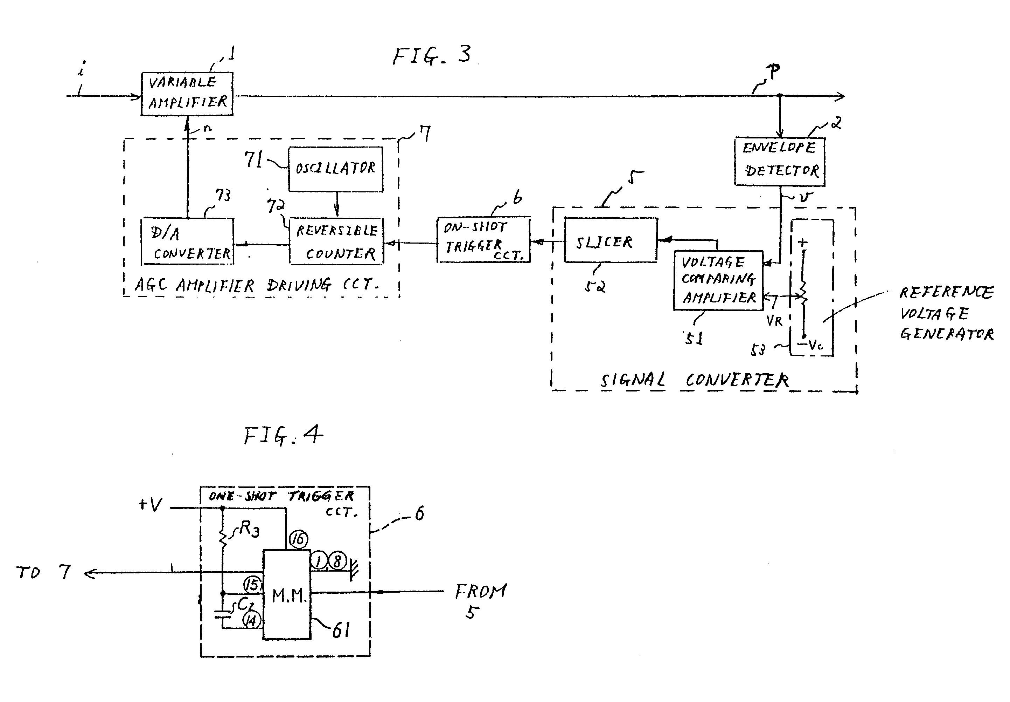

To obviating disadvantage of the prior art AGC circuit, the present invention provides an improved AGC circuit, as shown in FIG. 3, wherein components bearing the same symbols are identically structured with the corresponding components in FIG. 1. Thus, reference numeral 1 represents a variable amplifier, and 2, an envelope detector. In addition, 5 represents a signal converter for converting a signal envelope-detected by the envelope detector 2 into a binary signal by comparing the former with a presecribed threshold level $V_R$ ; 6, a pulse generator circuit consisting, for example, of one-shot trigger circuit for providing a pulse signal of a predetermined pulse width in response to the binary signal, and 7, a variable amplifier driving circuit, which is an AGC amplifier driving circuit for controlling the gain of the variable amplifier 1 by digitally processing the maintained signal. The signal converter 5 further comprises a voltage comparing amplifier 51, a slicer 52 and a reference voltage generator 53. The variable amplifier driving circuit 7 further comprises an oscillator circuit 71 for generating clock pulses of a clock frequency fc, a reversible counter 72 for counting up and down the clock pulses under control of output of the one-shot trigger circuit 6, and a D/A converter 73 for converting the output of the reversible counter 72 into an analog signal and controlling the gain of the variable amplifier 1. The AGC circuit includes a negative feedback circuit comprising the detector 2, the converter 5 and the circuits 6 and 7.

Next, the operation of the circuit illustrated in FIG. 3 will be described.

The voltage comparing amplifier 51 compares the output voltage v of the detector 2 and the reference voltage $V_R$ provided from the generator 53. The slicer 52 converts the output level of the amplifier 51 into a binary signal. Thus the converter 5 will provide, if the output voltage v of the detector 2 is higher than the reference voltage $V_R$, a high level (H) signal or, if the former fails to reach the latter, a low level (L) signal.

FIG. 4 illustrates a specific embodiment of the one-shot trigger circuit 6 shown in FIG. 3. In FIG. 4, 61 is a monostable multivibrator; $R_3$, a resistor and $C_2$, a capacitor. In this embodiment is used as monostable multivibrator 61 a μPB 74LS123D unit manufactured by NEC Corporation or an SN74LS123 unit manufactured by Texas Instruments Inc. Terminals ① and ⑧ of the monostable multivibrator 61 are grounded; a voltage +v is supplied to its terminal ⑯; the resistor $R_3$ is connected between its terminals ⑮ and ⑯, and the capacitor $C_2$ is provided between its terminals ⑭ and ⑮.

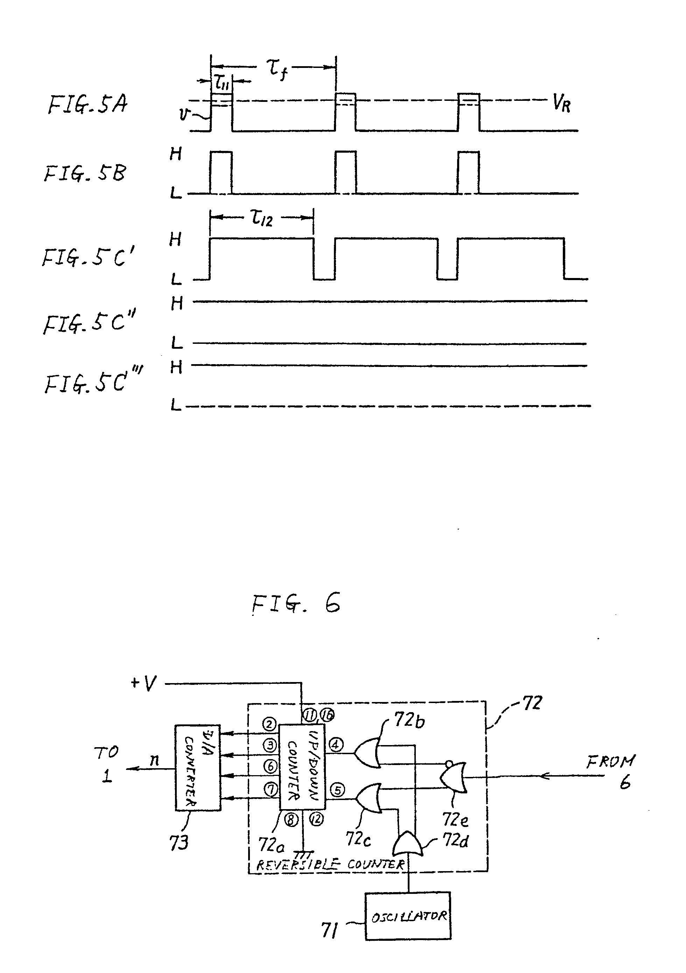

FIGS. 5A, 5B, 5C' and 5C''' consist of waveform diagrams for describing the operations of the signal converter 5 and the one-shot trigger circuit 6. In FIG. 5A, which shows the output waveform v of the detector 2, $\tau f$ represents the repetition time of the burst and $\tau_{11}$, the burst signal time. FIG. 5B shows the output waveform of the signal converter 5, the output signal being at a high level (H) if the voltage v of FIG. 5A is higher than the reference voltage $V_R$ or at a low level (L) if it is lower. The one-shot trigger circuit 6, upon receipt of the signal shown in FIG. 5B, extends by a time $\tau_{12}$ determined by the resistor $R_3$ and the capacitor $C_2$. If the monostable vibrator 61 shown in FIG. 4 is used, about 50 nsec (or $(50 \times 10^{-9}$ seconds) will be sufficient as the burst signal time $\tau_{11}$ to extend the signal by the time $\tau_{12}$ determined by the following equation:

$$\tau_{12} = 0.45 \times C_2 \times R_3$$

FIG. 5C' shows the output waveform of the one-shot trigger circuit 6 achieved when the burst signal time or pulse width $\tau_{12}$ is selected to be shorter than the burst repetition time, or the frame time $\tau_f$ ($\tau_{12} < \tau_f$). The waveform extended by the arrival of each preceding burst continues on to the waveform resulting from that of the immediately following burst, so that the output of the one-shot trigger circuit circuit 6 keeps the high level (H) as shown in FIG. 5C'''. Further, if the output v (FIG. 5A) of the detector 2 is lower than the reference voltage $V_R$ as represented by the dotted line, the output (FIG. 5B) of the signal converter 5 will be at the low level (L) as indicated by the dotted line therein, so that the output of the one-shot trigger circuit 6 will maintain the low level (L) shown in FIG. 5C'''.

Thus the use of the one-shot trigger circuit 6 shown in FIG. 4 makes it possible to keep its output at the high level (H) if signals of very short burst durations, whose voltage is higher than the reference voltage $V_R$, consecutively come in, and at the low level (L) in the absence of an incoming signal or if the voltage of the incoming signal does not exceed the reference voltage $V_R$. Since the one-shot trigger circuit 6 is a digital circuit, obviously its design can be so altered without difficulty that the circuit conversely give an output of the low level (L) in the presence of signals and one of the high level (H) in their absence. In applying the present invention, it is desirable to use a burst signal retaining time $\tau_{12}$ slightly shorter than the frame time $\tau_f$.

FIG. 6 illustrates a specific embodiment of the reversible counter 72 shown in FIG. 3, consisting of an up-down counter 72a and gate circuits 72b to 72d for driving the up-down counter 72a. The gate circuits 72b to 72d determine whether the output of the oscillator 71 having a clock frequency of fc shall be fed directly or as a D.C. voltage of the high level (H) to the input terminal ④ or ⑤ of the up-down counter 72a (for instance, μPB74LS193C manufacturec by NEC Corporation or SN74LS196C manufactured by Texas Instruments Inc. Depending on which terminal, ④ or ⑤ , receives the output of the oscillator 71, the up-down counter 72a will count either up or down. By connecting the

output terminals ②, ③, ⑥ and ⑦ to the D/A converter 73, a digital signal outputted from the reversible counter 72 is converted by the D/A converter 73 into an analog signal n, which is supplied to the variable amplifier 1.

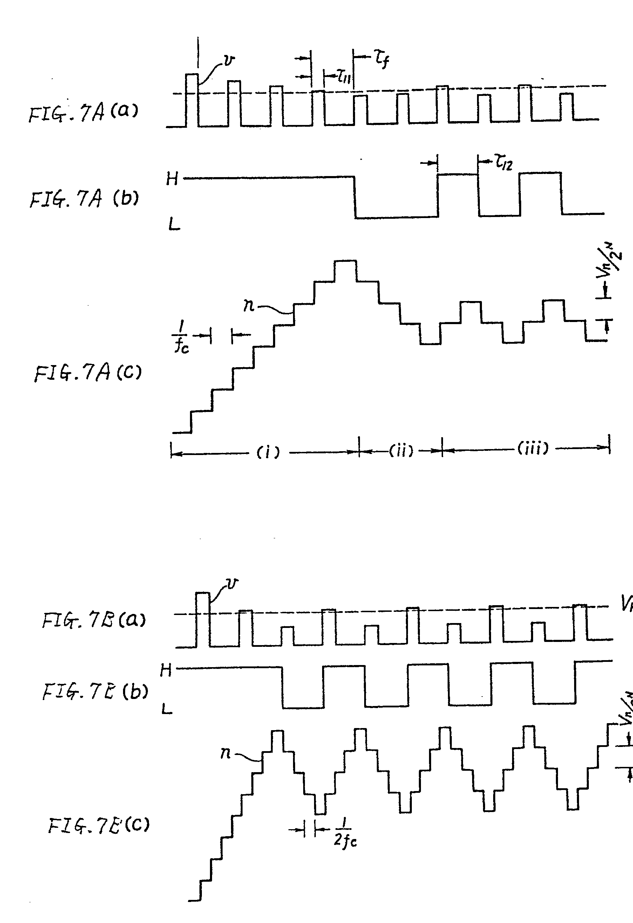

FIGs. 7A (a) to 7A(c) are waveform diagrams for describing the operation of the circuit illustrated in FIG. 3. FIG. 7A(a) shows the output waveform of the envelope detector 2; FIG. 7A(b), that of the one-shot trigger circuit 6, and FIG. 7A(c), that of the variable amplifier driving circuit 7. The figures show the initial states of the circuit, wherein the power of the output p of the AGC circuit for burst signals, illustrated in FIG. 3, is too great. In FIGS. 7A(a) to 7A(b), section (i) is where the output p is gradually decreasing; section (ii), where the output p is gradually increasing, and section (iii), where the output p is repeating alternate increases and decreases resulting in a stable output level. The gain of the variable amplifier 1 decreases with a rise in the voltage level of the control signal (analog signal) n supplied from the variable amplifier driving circuit 7, and vice versa.

Referring now to FIG. 7A(a), the output voltage v of the envelope detector 2 is higher than the reference voltage $V_R$ and gradually decreasing in section (i), where, as shown in FIG. 7A(b), the output of the one-shot trigger circuit 6 is at the high level (H) and the voltage level of the control signal n supplied from the variable amplifier driving circuit 7 is gradually rising. Next in section (ii), the output voltage v of the envelope detector 2, as shown in FIG. 7A(a), is lower than the reference voltage $V_R$ and gradually increasing. In this while, the output of the one-shot trigger circuit 6, as shown in FIG. 7A-(b), is at the low level (L), and the voltage level of the control signal n supplied from the variable amplifier dirving circuit 7, as shown in FIG. 7A(c), gradually lowers. Further in section (iii), the output voltage of the envelope detector 2, as shown in FIG. 7A(a), is alternately rising above and falling under the reference voltage $V_R$ in the cycles of the frame time $\tau f$ each. Then, the output of the one-shot trigger circuit 6, as shown in FIG. 7A(b), is altertately at the high level (H) and the low level (L), and the voltage level of the control signal supplied from the variable amplifier driving circuit 7 enters a stable state, as shown in FIG. 7A(c).

In the variable amplifier driving circuit 7, the clock frequency fc of the oscillator circuit 71 and the number of bits N of the D/A converter 73 can be varied in many ways depending on the requirement on the AGC circuit. Thus, if stability (section (iii) in FIG. 7A(a) to 7A(c)) has to be quickly achieved (i.e. the combined duration of sections (i) and (ii) has to be shortened), the clock frequency fc can be set higher or, if the range of fluctuation in the stable state has to be narrowed, the number of bits N of the D/A converter 73 can be increased. Therefore, as a variation of the embodiment illustrated in FIG. 3, there can be proposed a version whose oscillator circuit has two different clock frequencies, the higher one being selected when the output p of the AGC circuit for burst signals substantially deviates from its prescribed level, to be followed by a switch-over to the lower one when the stable state has been achieved.

The foregoing will be explained in further detail with reference to FIGS. 7B(a) to 7D(c). FIGS. 7B(a) to 7B(c) illustrate instances in which the number of bits of the D/A converter 73 is N like in FIGS. 7A(a) to 7A(c) and the clock frequency is 2fc, provided that the range of control voltage levels of the control signal n being represented by $V_n$. The figures show that the time taken to achieve stability is shorter than in the case of FIGS. 7A(a) to 7A(c).

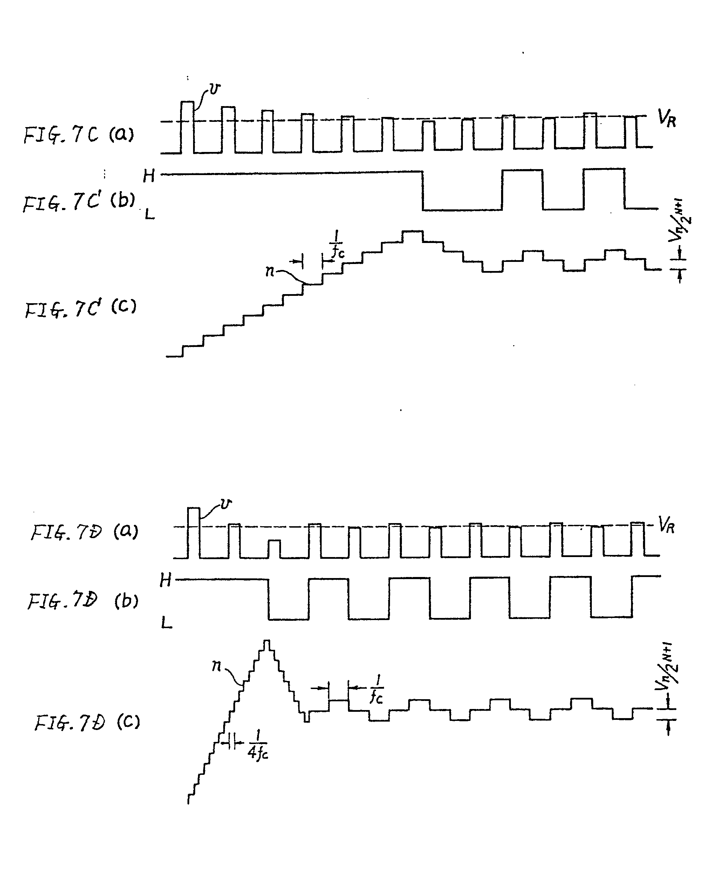

FIGS. 7C(a) to C(c) illustrate instances in which the clock frequency is fc like in the case of FIGS. 7A(a) to 7(c) and the number of bits of the D/A converter 73 is N + 1. It is seen that the range of fluctuation in the stable state is narrower than in the case of FIG. 7A.

FIGS. 7D(a) to 7D(c) illustrates instances in which the oscillating circuit has two different clock frequencies, fc and 4fc, and the number of bits of the D/A converter 73 is N + 1. The figures clearly show that stability can be more quickly achieved and the range of fluctuation in the stable state is narrower.

As hitherto described, there can be realized an AGC circuit for burst signals with little output fluctuation by structing a negative feedback circuit out of the envelope detector 2, the signal converter 5, the one-shot trigger circuit 6 and the variable amplifier driving circuit 7, and digitally processing the burst output of the envelope detector 2.

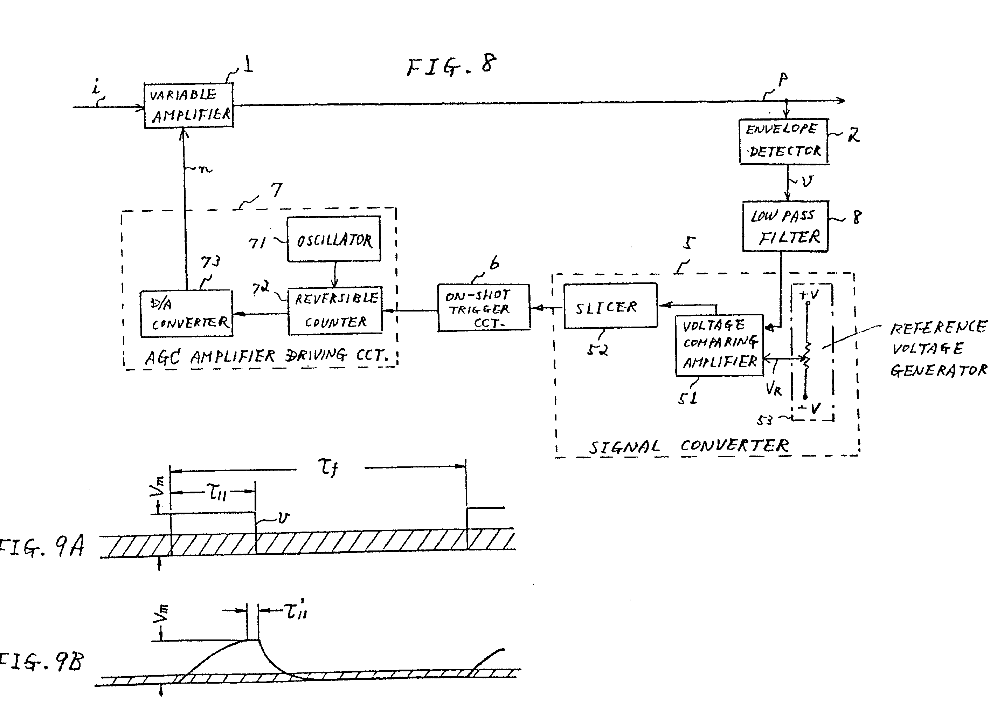

Since the one-shot trigger circuit 6 illustrated in FIG. 3 stably operates for very short burst signals even of 50 nsec each, it is possible to insert, as shown in FIG. 8, a low-pass filter (LPF) for improving the signal-to-noise (S/N) ratio between the envelope detector 2 and the signal converter 5 as illustrated in FIG. 3.

In FIGS. 9A and 9B, consisting of waveform diagrams for describing the operation of the circuit illustrated in FIG. 8, FIG. 9A shows the output waveform of the envelope detector 22 and FIG. 9B that of the LPF 8, the parts marked with oblique lines in both representing the thermal noise power component. As the figure indicates, the insertion of the LPF 8 serves to decrease the thermal noise power, but the rise of the detection voltage for burst signals is correspondingly delayed. In the circuit of prior art illustrated in FIG. 1, it is impossible to restrict the band and thereby improve the S/N ratio to its required level. In contrast, in the circuit according to the present invention illustrated in FIG. 8, the passing band of the LPF 8 can be sufficiently narrowed to reduce the time $\tau'_{11}$, during which the waveform having passed the LPF 8 manifests the maximum value $V_m$ of the pulse, to around 50 nsec. Therefore, the S/N ratio can be improved to its required level, so that there can be realized an AGC circuit for burst signals which can stably operate even if the thermal noise power substantially fluctuates.

It is assumed here that the present AGC circuit for burst signals is used in, for example, a receiver equipment for a satellite communications system. If the circuit is a conventional one as shown in FIG. 1, the peak will be held at a power value which is the sum of the power of signals received and that of thermal noise, or in other words the envelope-detected output in which the noise power has increased as a consequence of the state of the signal propagation path varied by rainfall and/or attenuation is peak-held as it is, the signal power component will equivalently decrease. In contrast, in the circuit according to the present invention illustrated in FIG. 8, the thermal noise power is reduced by the LPF 8, so that negative feedback is achieved to the original signal power involving little noise and the variation of the signal power component can be kept extremely small.

Although, in the circuit of FIG. 8, the LPF 8 is inserted on the output side of the envelope detector 2 of the circuit illustrated in FIG. 3, the same effect as that of the circuit of FIG. 8 can obviously be achieved by inserting a band pass filter on the input side of the envelope detector 2 of the circuit shown in FIG. 3.

As hitherto described, the present invention can provide for burst communications systems an AGC circuit whose output power variation is extremely small even if the burst time varies. Further since the invention permits the AGC circuit to operate free of trouble even if the burst time is very short and accordingly a filter can be inserted into the received burst detecting circuit to reduce noise, there can be realized an AGC circuit for signal reception whose received signal component will vary extremely little even if the received noise power fluctuates.

## Claims

1.  An automatic gain control (AGC) circuit for a burst signal communication system, comprising an AGC amplifier means (1) for receiving a burst input (i) and providing a burst output (p) whose level is controlled in response to a control signal (n), and a negative feedback circuit means (2, 5 to 7; 2 , 8, 5 to 7 ) for receiving the burst output (p) and providing the control signal (n), wherein the negative feedback circuit means comprises an envelope detector means (2) for envelope-detecting the burst output (p) and providing a first signal (v), converting means (5) for converting the first signal (v) into a binary signal by comparing it with a reference voltage ($V_R$), pulse generator means (6) for providing a pulse signal of a predetermined pulse width in response to the binary signal, and AGC amplifier driving circuit means (7) for digitally processing the pulse signal, thereby providing the control signal (n).

2.  An AGC circuit as claimed in claim 1, wherein the pulse generator means comprises a one-shot trigger circuit (6).

3.  An AGC circuit as claimed in Claim 2, wherein the one-shot trigger circuit comprises a monostable multvibrator (61), a resistor ($R_3$) and a capacitor ($C_2$).

4.  An AGC circuit as claimed in any of claims 1 to 3, wherein the AGC amplifier driving circuit means (7) comprises an oscillator circuit (71) for generating clock pulses, a reversible counter (72) for counting up and down the clock pulses in response to the pulse signal, and a D/A converter (73) for converting the output of the reversible counter and providing the control signal (n).

5.  An AGC circuit as claimed in any of claims 1 to 4, wherein the negative feedback cirucit means further comprises filter means (8) connected to the input or the output of the envelope detector means (2) for eliminating noise included in one of the burst output (p) and the first signal (v).

## Revendications

1.  Circuit de commande automatique de gain (CAG) pour un système de communication de signaux en rafale, comprenant un moyen d'amplificateur CAG (1) pour recevoir une entrée en rafale (i) et fournir une sortie en rafale (p) dont le niveau est contrôlé en réponse à un signal de commande (n), et un moyen de circuit de réaction négative (2, 5 à 7; 2, 8, 5 à 7) afin de recevoir la sortie en rafale (p) et fournir le signal de commande (n), dans lequel le moyen de circuit de réaction négative comprend un moyen (2) de détecteur d'enveloppe pour détecter la sortie en rafale (p) en matière d'enveloppe et fournir un premier signal (v), un moyen de conversion (5) pour convertir le premier signal (v) en signal binaire en le comparant à une tension de référence ($V_R$), un moyen (6) de générateur d'impulsions pour fournir un signal impulsionnel d'une largeur d'impulsion prédéterminée en réponse au signal binaire, et un moyen (7) de circuit d'attaque d'amplificateur CAG pour traiter numériquement le signal impulsionnel, d'où la fourniture du signal de commande (n).

2. Circuit CAG selon la revendication 1, dans lequel le moyen de générateur d'impulsions comprend un circuit de déclenchement monocoup (6).

3. Circuit CAG selon la revendication 2, dans lequel le circuit de déclenchement mono-coup comprend un multivibrateur monostable (61), une résistance ($R_3$) et un condensateur ($C_2$).

4. Circuit CAG selon l'une quelconque des revendications 1 à 3, dans lequel le moyen (7) de circuit d'attaque d'amplificateur CAG comprend un oscillateur (71) pour produire des impulsions d'horloge, un compteur réversible (72) pour compter dans le sens progressif et le sens dégressif les impulsions d'horloge en réponse au signal impulsionnel et un convertisseur N/A (73) pour convertir la sortie du compteur réversible et fournir le signal de commande (n).

5. Circuit CAG selon l'une quelconque des revendications 1 à 4, dans lequel le moyen de circuit de réaction négative comprend en outre un moyen de filtre (8) connecté à l'entrée ou à la sortie du moyen (2) de détecteur d'enveloppe afin d'éliminer le bruit inclus dans la sortie en rafale (p) et dans le premier signal (v).


## Ansprüche

1. Automatische Verstärkungsregelungsschaltung (AGC) für ein Burstsignalübertragungssystem mit einer AGC-Verstärkereinrichtung (1) zum Empfangen eines Bursteingangs (i) und um einen Burstausgang (p) zur Verfügung zu stellen, dessen Pegel entsprechend einem Regelsignal (n) geregelt wird, und mit einer negativen Rückkopplungsschaltungseinrichtung (2, 5 bis 7; 2, 8, 5 bis 7) zum Empfangen des Burstausgangs (p) und um das Regelsignal (n) zur Verfügung zu stellen, wobei die negative Rückkopplungsschaltung aufweist: einen Envelope-Detektor (2), um die Envelope des Burstausgangs (p) festzustellen und ein erstes Signal (v) zu erzeugen, einen Konverter (5), um das erste Signal (v) in ein binäres Signal durch Vergleichen mit einer Referenzspannung ($V_R$) umzuwandeln, einen Impulsgenerator, um ein Impulssignal mit einer vorbestimmten Impulsbreite als Reaktion auf das binäre Signal zu erzeugen, und eine AGC-Verstärker-Treiberschaltung (7), um das Impulssignal digital zu verarbeiten und dabei das Regelsignal (n) zu erzeugen.

2. AGC-Schaltung nach Anspruch 1, wobei der Impulsgenerator einen Einzelschritt-Triggerschaltkreis (6) aufweist.

3. AGC-Schaltung nach Anspruch 2, wobei der Einzelschritt-Triggerschaltkreis einen monostabilen Multivibrator (61), einen Widerstand ($R_3$) und einen Kondensator ($C_2$) aufweist.

4. AGC-Schaltung nach einem der Ansprüche 1 bis 3, wobei die AGC-Verstärker-Treiberschaltung (7) aufweist: einen Oszillator (71) zum Erzeugen von Taktimpulsen, einen reversiblen Zähler (72), um die Taktimpulse als Reaktion auf ein Impulssignal aufwärts und abwärts zu zählen, und einen D/A-Wandler (73), um den Ausgang des reversiblen Zählers zu wandeln und das Regelsignal (n) zu erzeugen.

5. AGC-Schaltung nach einem der Ansprüche 1 bis 4, wobei die negative Rückkopplungsschaltung ferner eine Filtereinrichtung (8) aufweist, die mit dem Eingang oder Ausgang des Envelope-Detektors (2) verbunden ist, um das Rauschen, das in einem der Burstausgänge (p) und dem ersten Signal (v) enthalten ist, zu beseitigen.

## FIG.1

## FIG.2A

## FIG.2B

## FIG.2C

FIG. 3

i → VARIABLE AMPLIFIER → P →

ENVELOPE DETECTOR — 2

v

AGC AMPLIFIER DRIVING CCT. — 7

OSCILLATOR — 71

REVERSIBLE COUNTER — 72

D/A CONVERTER — 73

ON-SHOT TRIGGER CCT. — 6

SLICER — 5, 52

VOLTAGE COMPARING AMPLIFIER — 51

VR — Vc — 53

REFERENCE VOLTAGE GENERATOR

SIGNAL CONVERTER

FIG. 4

ONE-SHOT TRIGGER CCT. — 6

+V

R₃

TO 7 ←

M.M. — 61

C₂

FROM 5

(16) (1,8) (15) (14)

EP 0 114 066 B1

FIG.5A

FIG.5B

FIG.5C'

FIG.5C"

FIG.5C'''

FIG. 6

FIG. 7A (a)

FIG. 7A (b)

FIG. 7A (c)

FIG. 7B (a)

FIG. 7B (b)

FIG. 7B (c)

FIG. 7C (a)

FIG. 7C' (b)

FIG. 7C' (c)

FIG. 7D (a)

FIG. 7D (b)

FIG. 7D (c)

FIG. 8

i → VARIABLE AMPLIFIER (1) → P →

ENVELOPE DETECTOR ~ 2
↓ v
LOW PASS FILTER ~ 8

7
71 ~ OSCILLATOR

72 ~ REVERSIBLE COUNTER

73 ~ D/A CONVERTER

AGC AMPLIFIER DRIVING CCT.

6
ON-SHOT TRIGGER CCT.

5
SLICER
52

VOLTAGE COMPARING AMPLIFIER
51

REFERENCE VOLTAGE GENERATOR
+V
VR
-V
53

SIGNAL CONVERTER

n

FIG. 9A

τf
τ11
Vm
v

FIG. 9B

Vm
τ11'

EP 0 114 066 B1

13